(19) Europäisches Patentamt / European Patent Office / Office européen des brevets

(11) **EP 2 325 890 A1**

(12) **DEMANDE DE BREVET EUROPEEN**

(43) Date de publication:
**25.05.2011 Bulletin 2011/21**

(51) Int Cl.:
*H01L 29/08* (2006.01)   *H01L 29/36* (2006.01)
*H01L 29/735* (2006.01)   *H01L 29/06* (2006.01)
*H01L 29/40* (2006.01)

(21) Numéro de dépôt: **10191969.4**

(22) Date de dépôt: **19.11.2010**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **24.11.2009 FR 0958310**

(71) Demandeurs:
• **STMicroelectronics (Tours) SAS
37100 Tours (FR)**
• **Universite Francois Rabelais de Tours
37200 Tours (FR)**

(72) Inventeurs:
• **Quoirin, Jean Baptiste
37100 Tours (FR)**
• **Phung, Luong Viêt
37540 Saint Cyr Sur Loire (FR)**
• **Batut, Nathalie
37340 Hommes (FR)**

(74) Mandataire: **de Beaumont, Michel
Cabinet Michel de Beaumont
1, rue Champollion
38000 Grenoble (FR)**

(54) **Interrupteur de puissance bidirectionnel commandable à la fermeture et à l'ouverture**

(57)   L'invention concerne un transistor de puissance symétrique formé horizontalement dans une couche semiconductrice (31) reposant sur une tranche semiconductrice (35) fortement dopée avec interposition d'une couche isolante (33), la tranche étant adaptée à être polarisée à une tension de référence, le produit entre la concentration moyenne de dopants et l'épaisseur de la couche semiconductrice (31) étant compris entre $5.10^{11}$ $cm^{-2}$ et $5.10^{12}$ $cm^{-2}$.

Fig 3

**EP 2 325 890 A1**

**Description**

Domaine de l'invention

La présente invention concerne un interrupteur monolithique de puissance bidirectionnel et commandable à la fermeture et à l'ouverture.

Exposé de l'art antérieur

On appelle ici "interrupteur de puissance" un interrupteur susceptible de commuter des tensions supérieures à 100 volts et/ou des courants supérieurs à 1 ampère. Un interrupteur de puissance est par exemple destiné à commuter l'alimentation d'une charge connectée au secteur. Un interrupteur de puissance est généralement formé verticalement dans un substrat semiconducteur, c'est-à-dire que le courant entre les électrodes principales de l'interrupteur circule entre les faces supérieure et inférieure du substrat semiconducteur. Ceci distingue les interrupteurs de puissance des composants d'un circuit intégré qui sont généralement horizontaux, c'est-à-dire que les électrodes principales de ces composants sont situées sur une même face du substrat semiconducteur et que le courant circule horizontalement entre ces électrodes principales.

Comme interrupteur de puissance, on peut utiliser un dispositif commandable à la fermeture et à l'ouverture tel qu'un transistor MOS vertical. Cependant, un transistor MOS vertical est unidirectionnel et il est nécessaire de l'associer à un pont de diodes si on veut commander un courant alternatif. Cette association a l'inconvénient de présenter une chute de tension non négligeable à l'état passant. Il en est de même dans le cas d'un transistor bipolaire.

On peut également utiliser un composant bidirectionnel tel qu'un triac qui a l'avantage de présenter une très faible chute de tension à l'état passant. Cependant, ce composant présente l'inconvénient de ne pas être commandable à l'ouverture, sauf à lui associer un circuit de commande complexe.

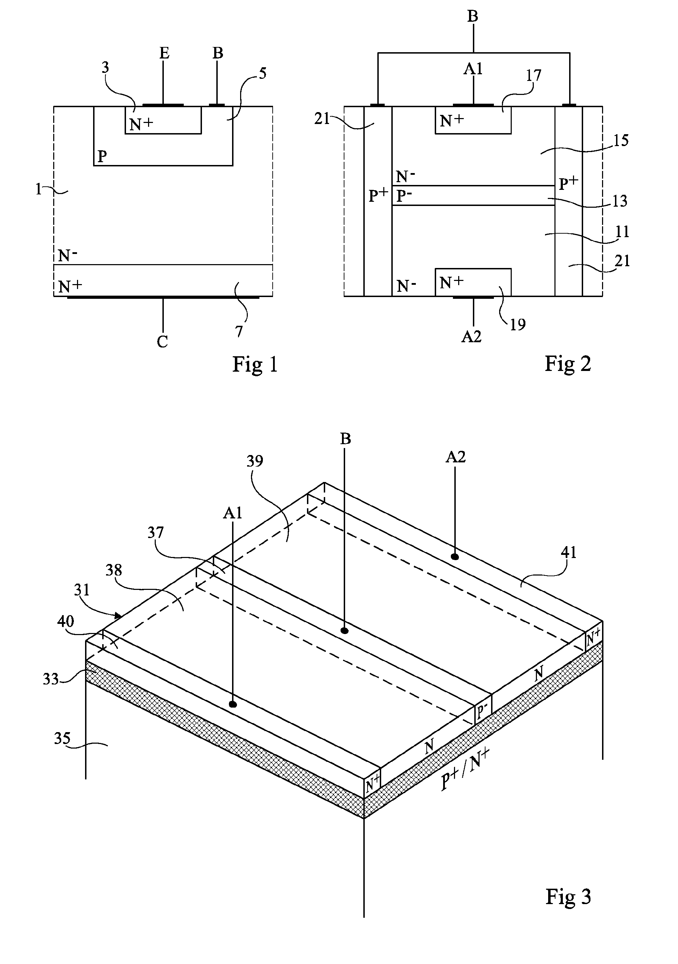

La figure 1 représente un transistor de puissance bipolaire vertical de type NPN. En surface d'un substrat semiconducteur 1 faiblement dopé de type N (N$^-$) est formée une région 3 fortement dopée de type N (N$^+$) dans un caisson 5 de type P. Le substrat 1 et la région 3 forment, respectivement, le collecteur et l'émetteur du transistor. Le caisson 5 forme la base du transistor. Sur la face inférieure du substrat 1 est formée une couche 7 fortement dopée de type N de contact de collecteur. Des métallisations d'émetteur E, de base B, et de collecteur C, sont formées, respectivement, sur les régions 3, 5 et 7.

Le substrat 1 est relativement épais, ce qui permet d'obtenir une tension de claquage à l'état bloqué importante. En effet, le silicium intrinsèque peut supporter environ 10 V par micromètre de silicium. Ainsi, une structure verticale comprenant un substrat 1 ayant une épaisseur de l'ordre de 60 µm peut supporter, à l'état bloqué, une tension de l'ordre de 600 V.

Si on veut obtenir un transistor de puissance à fonctionnement bidirectionnel, on peut penser à symétriser la structure de la figure 1, par exemple de la façon illustrée en figure 2.

La structure de la figure 2 comprend un empilement d'une première couche semiconductrice 11 épaisse faiblement dopée de type N, d'une fine couche 13 faiblement dopée de type P et d'une seconde couche 15 épaisse faiblement dopée de type N. La couche 13 forme la base du transistor symétrique et les couches 11 et 15 en forment des régions d'émetteur/collecteur. Des régions de contact d'émetteur/collecteur 17 et 19, fortement dopées de type N, sont formées, respectivement, sur la face supérieure de la couche 15 et sur la face inférieure de la couche 11. Un puits 21, fortement dopé de type P (P$^+$), traverse les couches semiconductrices 15 et/ou 11 et contacte la région de base 13. Des métallisations d'émetteur/collecteur A1, A2 et de base B sont formées, respectivement, sur les régions 17, 19 et 21.

La structure symétrique de la figure 2 ne peut cependant pas fonctionner correctement. En effet, les régions d'émetteur/collecteur 15 et 11 sont faiblement dopées de type N, ce qui en fait des régions de collecteur efficaces (tension de claquage élevée) mais de mauvaises régions d'émetteur ne permettant pas une bonne injection de porteurs à l'état passant. Ainsi, dans les deux sens de fonctionnement, la structure de la figure 2 présente un gain faible. Pour améliorer l'injection de porteurs à l'état passant, il faudrait augmenter le dopage des régions 15 et 11, mais alors la tension de claquage serait réduite. De plus, les techniques actuelles permettent difficilement la formation d'une région de base 13 fine et profondément enterrée et la formation d'un puits 21 pose des problèmes et peut provoquer des effets parasites.

Ainsi, il existe un besoin d'un interrupteur de puissance bidirectionnel, commandable à la fermeture et à l'ouverture.

Résumé

Un objet d'un mode de réalisation de la présente invention est de pallier au moins certains des inconvénients des interrupteurs de puissance bidirectionnels existants, commandables à la fermeture et à l'ouverture.

Un autre objet d'un mode de réalisation de la présente invention est de prévoir un transistor de puissance bidirectionnel ayant, à l'état passant, un gain élevé.

Un autre objet d'un mode de réalisation de la présente invention est de prévoir un tel transistor ayant, lorsqu'il est bloqué, une tension de claquage élevée.

Ainsi, un mode de réalisation de la présente invention prévoit un transistor de puissance symétrique formé horizontalement dans une couche semiconductrice reposant sur une tranche semiconductrice fortement dopée avec interposition d'une couche isolante, la tranche étant adaptée à être polarisée à une tension de référence, le produit entre la concentration moyenne de dopants et l'épaisseur de la couche semiconductrice étant compris entre $5.10^{11}$ cm$^{-2}$ et $5.10^{12}$ cm$^{-2}$.

Selon un mode de réalisation de la présente invention, le produit entre la concentration moyenne de dopants et l'épaisseur de la couche semiconductrice est compris entre $9.10^{11}$ et $2.10^{12}$ cm$^{-2}$.

Selon un mode de réalisation de la présente invention, le transistor comprend, dans la couche semiconductrice :

une bande semiconductrice faiblement dopée d'un premier type de conductivité, à un niveau de dopage inférieur à $5.10^{15}$ at./cm$^3$ ; et
deux régions dopées d'un second type de conductivité, à un niveau de dopage compris entre $10^{15}$ et $8.10^{17}$ at./cm$^3$, situées symétriquement par rapport à la bande semiconductrice.

Selon un mode de réalisation de la présente invention, le niveau de dopage de chacune des régions dopées du second type de conductivité est croissant, en partant de la bande semiconductrice.

Selon un mode de réalisation de la présente invention, le dopage des régions dopées du second type de conductivité s'échelonne dans une plage dont la borne inférieure est comprise entre $10^{15}$ et $5.10^{15}$ at./cm$^3$ et dont la borne supérieure est comprise entre $5.10^{16}$ et $8.10^{17}$ at./cm$^3$.

Selon un mode de réalisation de la présente invention, le transistor comprend en outre des doigts fortement dopés du premier type de conductivité traversant la bande semiconductrice et s'étendant de part et d'autre de la bande dans les régions dopées du second type de conductivité.

Selon un mode de réalisation de la présente invention, la bande semiconductrice a une largeur inférieure à 2 $\mu$m.

Selon un mode de réalisation de la présente invention, le transistor comprend en outre une seconde couche isolante formée sur la couche semiconductrice et surmontée d'une seconde couche conductrice connectée à la bande semiconductrice.

Selon un mode de réalisation de la présente invention, le transistor est de type interdigité.

Selon un mode de réalisation de la présente invention, le transistor est de type bipolaire, la bande faiblement dopée du premier type de conductivité formant une base et les régions dopées du second type de conductivité formant des régions d'émetteur/collecteur.

Selon un mode de réalisation de la présente invention, le transistor est de type MOS, les régions dopées du second type de conductivité formant des régions de drain/source, le transistor comprenant en outre une grille isolée formée sur la bande semiconductrice faiblement dopée du premier type de conductivité.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1, précédemment décrite, illustre un transistor de puissance vertical connu ;
la figure 2, précédemment décrite, illustre un transistor de puissance vertical symétrique ;
la figure 3 est une vue en perspective d'un transistor de puissance bidirectionnel selon un mode de réalisation de la présente invention ;
la figure 4 est une vue de dessus d'une variante d'un transistor selon un mode de réalisation de la présente invention ;
la figure 5 est une vue en coupe illustrant un effet avantageusement produit avec un transistor selon un mode de réalisation de la présente invention ;
la figure 6 est une vue en coupe illustrant une variante d'un transistor selon un mode de réalisation de la présente invention ;
les figures 7A et 7B illustrent un avantage d'une variante d'un transistor selon un mode de réalisation de la présente invention ; et
la figure 8 illustre un exemple de structure d'un transistor selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Description détaillée

La figure 3 est une vue en perspective d'un transistor bidirectionnel selon un mode de réalisation de la présente invention. Contrairement aux transistors de puissance connus qui sont généralement verticaux, le transistor de la figure 3 est horizontal. Ceci permet de s'affranchir des problèmes de formation de bases fines et profondes des transistors symétriques verticaux et des problèmes provoqués par la présence de puits d'accès à ces bases.

Le transistor est formé dans une couche semiconductrice 31 qui s'étend sur une couche isolante 33, la couche isolante 33 s'étendant sur une tranche semiconductrice 35 fortement dopée polarisée à une tension de référence. Dans l'exemple représenté, le transistor est un transistor NPN. On notera que l'on pourra former un transistor PNP de la même façon, en inversant tous les types de conductivité. A titre d'exemple, la couche isolante 33 peut être en oxyde de silicium. On notera également que des murs isolants (non représentés), traversant la couche de silicium 31 et atteignant la couche isolante 33, pourront être formées tout autour du transistor de la figure 3.

La couche semiconductrice 31 est dopée de type N. Au centre de la couche semiconductrice 31 est formée une bande 37 faiblement dopée de type P (P$^-$) qui traverse la couche 31 et la sépare en deux portions 38 et 39. La portion 38 forme l'émetteur, respectivement le collecteur, du transistor et la portion 39 forme le collecteur, respectivement l'émetteur, de celui-ci. La bande 37 forme la base du transistor et une métallisation B est formée en surface de la bande 37. De part et d'autre de la bande 37, aux extrémités opposées des portions 38 et 39, sont formées, symétriquement, des bandes fortement dopées de type N (N$^+$) formant des régions de contact d'émetteur/collecteur 40 et de contact de collecteur/émetteur 41 sur lesquelles sont formées des métallisations A1 et A2.

Le fait que le transistor soit de type horizontal permet un accès direct à la base 37. De plus, on peut former une bande de base 37 aussi fine que souhaité. A titre d'exemple de valeurs numériques, la bande 37 peut avoir une largeur inférieure à 2 μm.

Le transistor de la figure 3 est bidirectionnel et peut ainsi être utilisé comme interrupteur commandable destiné à faire passer un courant alternatif, par exemple destiné à être connecté sur le secteur. En effet, on va montrer que, pour un dopage choisi de la couche semiconductrice 31, à condition d'optimiser l'épaisseur de cette couche, quand le transistor est bloqué, la partie du transistor correspondant à sa région de collecteur est déplétée.

Plus particulièrement, on choisit un niveau de dopage (n) pour la couche semiconductrice 31 permettant une injection satisfaisante pour la portion de cette couche fonctionnant en émetteur, et on fixe l'épaisseur (t$_{SOI}$) de cette couche de telle façon que :

$$\mathtt{n.t_{SOI} \# \varepsilon_S.E_{cr}/q \# 10^{12}\ cm^{-2}}$$

où $\varepsilon$s est la permittivité diélectrique de la couche semiconductrice 31, E$_{cr}$ est le champ critique de la couche semiconductrice 31, et q est la charge de l'électron.

En d'autres termes, on choisit l'épaisseur (t$_{SOI}$) de la couche semiconductrice 31 en fonction de son niveau de dopage (n) de la façon suivante :

$$\mathtt{t_{SOI} \# 10^{12}/n\ cm,}$$

de préférence

$$\mathtt{5.10^{11}/n < t_{SOI} < 5.10^{12}/n\ cm.}$$

Dans ces conditions de dopage et d'épaisseur, quand la tranche semiconductrice 35 fortement dopée, de type N ou de type P, est polarisée à une tension de référence et lorsque le transistor formé dans la couche semiconductrice 31 est à l'état bloqué, il se produit un effet dit "resurf" (de l'anglais REduced SURface Field), qui entraîne que la portion de couche semiconductrice polarisée en collecteur bloqué se déplète totalement et acquiert donc un niveau de dopage apparent très inférieur à son niveau de dopage réel.

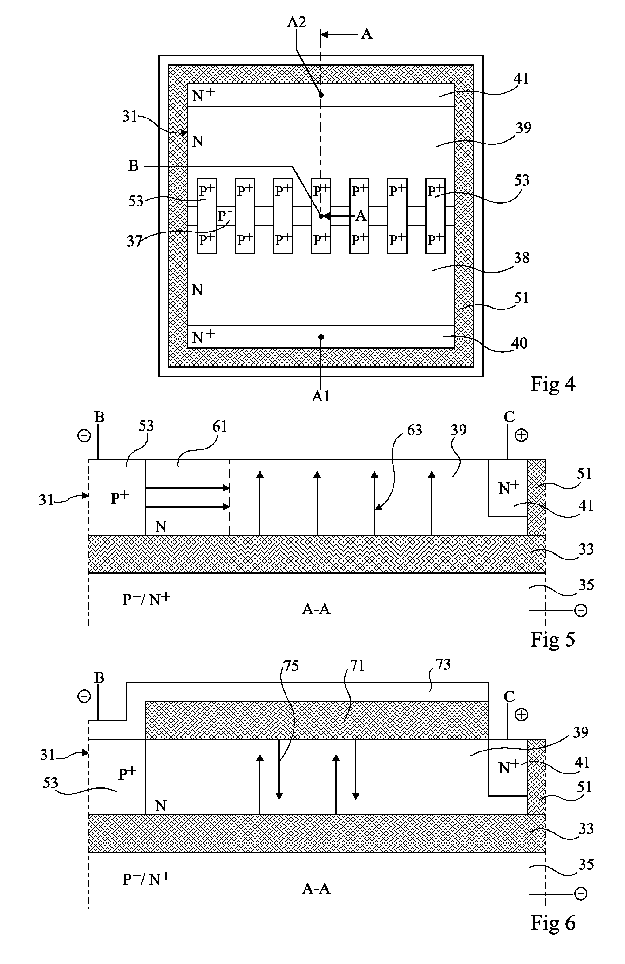

La figure 4 est une vue de dessus d'une variante d'un transistor selon un mode de réalisation de la présente invention. On peut voir les régions d'émetteur/collecteur 38, 39 faiblement dopées de type N situées symétriquement par rapport à la région de base 37 ayant une forme de bande. Les régions de contact d'émetteur/collecteur 40, 41 fortement dopées de type N sont disposées de part et d'autre des régions d'émetteur/collecteur 38, 39. Un mur de matériau isolant 51 traversant la couche semiconductrice 31 entoure le transistor. Dans cette variante, des doigts 53 fortement dopés de type P traversent la bande 37 et s'étendent, orthogonalement à la bande 37, de part et d'autre de celle-ci. Les doigts 53 s'étendent dans les régions d'émetteur/collecteur 38, 39 sur une longueur qui sera choisie de façon appropriée en fonction de la distance entre les doigts 53. Les doigts 53 sont nombreux et permettent de protéger la base 37, relativement fine, à l'état bloqué. En effet, dans cet état, la présence des doigts fortement dopés 53 permet de former deux zones de charge d'espace électriques en vis-à-vis entre chaque doigt 53 au voisinage de la base 37. Ces champs électriques se compensent, ce qui permet de générer, autour de la base 37, une zone exempte de champ électrique. On évite ainsi un claquage au voisinage de la base.

La figure 5 est une vue en coupe d'une moitié du transistor de la figure 4 selon la ligne de coupe A-A de cette figure. Plus particulièrement on a représenté la moitié du transistor côté collecteur quand celui-ci est polarisé à l'état bloqué. L'effet "resurf" mentionné ci-dessus entraîne que, en plus de la région déplétée 61 voisine de la jonction collecteur-base, il se forme une région déplétée désignée par les flèches 63 qui s'étend jusqu'à la surface de la région de collecteur 39 si l'épaisseur de celle-ci satisfait aux conditions indiquées ci-dessus. Ainsi, lorsque le transistor est bloqué, il peut supporter une tension importante entre base et collecteur. La déplétion de la région de collecteur 39 à l'état bloqué autorise une augmentation du dopage de la couche 31. Ceci permet une injection de porteurs importante entre émetteur et base quand on veut rendre le transistor passant. A titre d'exemple, le dopage de la couche semiconductrice 31 peut être compris entre $10^{15}$ et $8.10^{17}$ at./cm$^3$, de préférence supérieur à $5.10^{15}$ at./cm$^3$.

La figure 6 illustre une variante de la structure de la figure 5. En plus des éléments de la figure 5, une couche isolante 71 est formée au-dessus de la couche semiconductrice 31 et est recouverte d'une couche conductrice 73, par exemple en métal ou en semiconducteur dopé, qui contacte la région de base 37. Ainsi, lorsque le transistor est bloqué, c'est-à-dire que la base est au potentiel le plus bas et le collecteur au potentiel le plus haut, un effet "resurf" se crée également à partir de la surface supérieure de la couche 31, du fait de l'ajout de la couche isolante 71 et de la couche conductrice 73, comme cela est représenté par des flèches 75. Ainsi, on peut dépléter une épaisseur plus importante de couche semiconductrice 31 et donc prévoir une couche 31 plus épaisse qui permet le passage d'un courant, à l'état passant, plus important dans le transistor. On peut également, plutôt que d'augmenter l'épaisseur de la couche 31, augmenter encore le dopage de cette couche 31 pour permettre, à l'état passant, le passage d'un courant plus important.

Les inventeurs ont étudié la répartition des lignes équipotentielles dans un dispositif tel que celui de la figure 4, à l'état bloqué, et ils se sont rendus compte que ces lignes étaient concentrées autour de la région de collecteur.

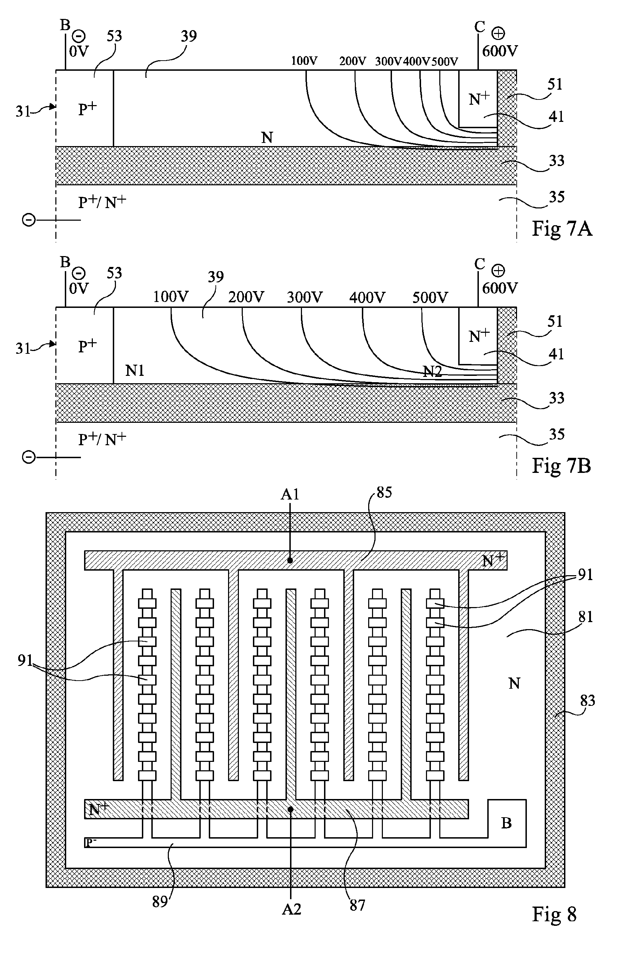

La figure 7A est une vue en coupe selon la ligne A-A qui illustre un exemple de répartition de lignes équipotentielles dans ce cas. On considère ici que le contact de collecteur est connecté à une tension de 600 V et la base à une tension de 0 V. Les lignes équipotentielles (500 V, 400 V...) se concentrent à proximité du contact de collecteur. Ainsi, les premiers micromètres de la région de collecteur 39 situés près du contact de collecteur 41 doivent supporter la quasi-totalité des 600 V. Ceci peut provoquer un claquage.

Pour résoudre ce problème, les inventeurs proposent de former des régions d'émetteur/collecteur 38 et 39 dont le dopage est graduel entre la région de base et les régions de contact d'émetteur, respectivement de collecteur.

La figure 7B illustre la répartition des lignes équipotentielles dans une telle structure. Dans cette figure, la tension de 600 V entre la base et le contact de collecteur 41 se répartit sensiblement sur toute la longueur de la région de collecteur 39. Ainsi, on limite les risques de claquage de cette couche. A titre d'exemple de valeur numérique, le dopage le plus faible (N1) de la région de collecteur 39, du côté de la base, pourra être compris entre $10^{15}$ et $5.10^{15}$ at./cm$^3$, par exemple de l'ordre de $5.10^{15}$ at./cm$^3$ et le dopage le plus fort (N2), du côté du contact de collecteur 41, pourra être compris entre $5.10^{16}$ et $8.10^{17}$ at./cm$^3$, par exemple de l'ordre de $6.10^{17}$ at./cm$^3$ pour une longueur entre la base et le contact de collecteur de l'ordre de 35 $\mu$m et une couche semiconductrice 31 ayant une épaisseur d'environ 1,5 $\mu$m.

Ainsi, on obtient un transistor bidirectionnel ayant, à l'état passant, un gain élevé et une chute de tension faible du fait du dopage progressif et élevé des régions d'émetteur 38 et de collecteur 39 (jusqu'à $8.10^{17}$ at./cm$^3$). A l'état bloqué, le transistor supporte des tensions élevées puisque la couche semiconductrice 31 est complètement déplétée et que les lignes équipotentielles entre les régions de base et de contact de collecteur sont réparties dans toute la longueur de la région de collecteur.

A titre d'exemple de valeurs numériques, avec un dispositif ayant les caractéristiques suivantes :

- épaisseur de la couche isolante 33 : 3 $\mu$m;
- épaisseur de la couche isolante 71 : 3 pu
- dopage de la bande de base 37 : $2,25.10^{15}$ at./cm$^3$
- dopage des doigts 53 : $3.10^{19}$ at./cm$^3$
- dopages minimum et maximum de la couche semiconductrice 31 :

$$N1 = 5.10^{15} \text{ at./cm}^3, \ N2 = 6.10^{16} \text{ at./cm}^3$$

- épaisseur de la couche semiconductrice 31 : 1,5 µm,

on obtient un transistor ayant un gain de l'ordre de 44, des pertes de l'ordre de 2,58 W pour un courant de 5 A, et nécessitant une surface de substrat de seulement environ 1,5 cm$^2$.

De plus, le transistor décrit ici peut être obtenu par un procédé simple, classique.

La figure 8 est une vue de dessus d'un mode de réalisation d'un transistor de puissance dont les régions d'émetteur, de collecteur et de base sont interdigitées.

Une couche semiconductrice 81 dopée de type N s'étend sur une couche isolante non représentée. Un mur isolant 83 entoure le transistor et traverse la couche semiconductrice 81. Des régions de contact d'émetteur/collecteur 85 et de collecteur/émetteur 87, fortement dopées de type N (N$^+$), sont formées dans la couche semiconductrice 81. Les régions 85 et 87 sont constituées d'une bande principale à partir de laquelle s'étendent de nombreuses bandes plus fines. Les bandes plus fines des régions 85 et 87 sont interdigitées dans la couche 81. Une région de base 89, faiblement dopée de type P (P$^-$) est également formée dans la couche semiconductrice 81. Cette région 89 est également constituée d'une bande principale d'où s'étendent des bandes plus fines. Chaque bande plus fine de la base 89 est située, dans la couche semiconductrice 81, entre les bandes fines des régions de contact d'émetteur 85 et de collecteur 87. Des doigts 91 fortement dopés de type P, similaires aux doigts 53 de la figure 4, traversent les bandes plus fines de la région de base 89 et s'étendent de part et d'autre de ces bandes.

La couche semiconductrice 81 pourra avoir un dopage progressif entre chacune des bandes fines de base 89 et chacune des bandes fines d'émetteur/collecteur 85 et 87, pour favoriser la répartition des lignes de champ dans la couche semiconductrice 81 lorsque le transistor est bloqué.

La structure interdigitée de la figure 8 permet de former, sur une surface réduite de substrat, un transistor constitué de plusieurs transistors en parallèle qui ont, à l'état passant, un gain élevé. La tension supportée aux bornes principales du transistor à l'état bloqué pourra également être importante.

Des modes de réalisation particuliers de la présente invention ont été décrits. Diverses variantes et modifications apparaîtront à l'homme de l'art. En particulier, on notera que l'on pourra inverser tous les types de conductivité donnés ici pour former non pas un transistor de puissance de type NPN mais un transistor de type PNP.

De plus, bien que l'on ait décrit ici la structure d'un transistor bipolaire, on notera que, en formant une grille isolée en surface de la bande 37, on pourra également former un transistor bidirectionnel à commande MOS.

## Revendications

1. Transistor de puissance bidirectionnel formé horizontalement dans une couche semiconductrice (31) reposant sur une tranche semiconductrice (35) fortement dopée avec interposition d'une couche isolante (33), la tranche étant adaptée à être polarisée à une tension de référence, le produit entre la concentration moyenne de dopants et l'épaisseur de la couche semiconductrice étant compris entre 5.10$^{11}$ cm$^{-2}$ et 5.10$^{12}$ cm$^{-2}$, ledit transistor comprenant en outre, dans la couche semiconductrice (31), une bande semiconductrice (37) faiblement dopée d'un premier type de conductivité, à un niveau de dopage inférieur à 5.10$^{15}$ at./cm$^3$ ; et deux régions (38, 39) dopées d'un second type de conductivité, à un même niveau de dopage compris entre 10$^{15}$ et 8.10$^{17}$ at./cm$^3$, situées symétriquement par rapport à la bande semiconductrice (37).

2. Transistor selon la revendication 1, dans lequel ledit produit est compris entre 9.10$^{11}$ et 2.10$^{12}$ cm$^{-2}$.

3. Transistor selon la revendication 1 ou 2, dans lequel le niveau de dopage de chacune des régions (38, 39) dopées du second type de conductivité est croissant, en partant de la bande semiconductrice (37).

4. Transistor selon la revendication 3, dans lequel le dopage desdites régions (38, 39) s'échelonne dans une plage dont la borne inférieure est comprise entre 10$^{15}$ et 5.10$^{15}$ at./cm$^3$ et dont la borne supérieure est comprise entre 5.10$^{16}$ et 8.10$^{17}$ at./cm$^3$.

5. Transistor selon l'une quelconque des revendications 1 à 4, comprenant en outre des doigts (53) fortement dopés du premier type de conductivité traversant la bande semiconductrice (37) et s'étendant de part et d'autre de ladite bande dans lesdites régions (38, 39).

**6.** Transistor selon la revendication 5, dans lequel la bande semiconductrice (37) a une largeur inférieure à 2 $\mu$m.

**7.** Transistor selon l'une quelconque des revendications 1 à 6, comprenant en outre une seconde couche isolante (71) formée sur la couche semiconductrice (31) et surmontée d'une seconde couche conductrice (73) connectée à la bande semiconductrice (37).

**8.** Transistor selon l'une quelconque des revendications 1 à 7, de type interdigité.

**9.** Transistor selon l'une quelconque des revendications 1 à 8, de type bipolaire, dans lequel la bande (37) faiblement dopée du premier type de conductivité forme une base, et lesdites régions (38, 39) forment des régions d'émetteur/ collecteur.

**10.** Transistor selon l'une quelconque des revendications 1 à 8, de type MOS, dans lequel lesdites régions (38, 39) forment des régions de drain/source, le transistor comprenant en outre une grille isolée formée sur la bande semiconductrice (37) faiblement dopée du premier type de conductivité.

## Fig 1

E    B

3    N+    5

P

1

N-

N+

C    7

## Fig 2

B

A1    17

21    N+

P+    N-    P+    15

P-    13

11

21

N-    N+

A2    19

## Fig 3

B

39

A1    A2

37    41

38

31

40    N+

N+    N

33

P-

35    N

N+    P+ / N+

Fig 4

Fig 5

Fig 6

B ⊖
0V    53    39              100V  200V  300V 400V 500V
                                                        N⁺        51
31 →    P⁺                                                        41

                    N                                             33

P⁺/ N⁺                                                           35
⊖

Fig 7A

B ⊖
0V    53         39
                      100V       200V      300V      400V      500V    C ⊕
                                                                        600V
31 →    P⁺                                                       N⁺     51
              N1                                                        41
                                                    N2           33
P⁺/ N⁺
⊖
                                                                       35

Fig 7B

A1        85
                                                    N⁺
                                                                91
                                                                81
91
                                                    N            83

                    N⁺                              B
                    P⁻

89        A2      87

Fig 8

Europäisches
Patentamt

European
Patent Office

Office européen
des brevets

# RAPPORT DE RECHERCHE EUROPEENNE

Numéro de la demande

EP 10 19 1969

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | M. RODDER, D. A. ANTONIADIS: "Silicon-On-Insulator Bipolar Transistors", 8179 IEEE ELECTRON DEVICE LETTERS, vol. 4, no. 6, 1 juin 1983 (1983-06-01), pages 193-195, XP001291956, NY * Fig. 1 et texte correspondante. * ----- | 1,2,6-10 | INV. H01L29/08 H01L29/36 H01L29/735 H01L29/06 H01L29/40 |
| Y | CAO G J ET AL: "RESURFED LATERAL BIPOLAR TRANSISTORS FOR HIGH-VOLTAGE, HIGH-FREQUENCY APPLICATIONS", 12TH. INTERNATIONAL SYMPOSIUM ON POWER SEMICONDUCTOR DEVICES AND IC S. ISPSD 2000. PROCEEDINGS. TOULOUSE, FRANCE, MAY 22 - 25, 2000; [INTERNATIONAL SYMPOSIUM ON POWER SEMICONDUCTOR DEVICES & IC'S], NEW YORK, NY : IEEE, US LNKD-DOI:10.1109/ISPSD.2000, 22 mai 2000 (2000-05-22), pages 185-187, XP000987856, ISBN: 978-0-7803-6269-7 * le document en entier * * figure 1 * ----- | 1,2,6-10 | |
| A | US 6 972 466 B1 (LIANG MINCHANG [US] ET AL) 6 décembre 2005 (2005-12-06) * colonne 3, ligne 63 - colonne 9, ligne 43; figures 1, 2, 4, 12 * ----- | 1-10 | DOMAINES TECHNIQUES RECHERCHES (IPC) H01L |

-/--

Le présent rapport a été établi pour toutes les revendications

| Lieu de la recherche | Date d'achèvement de la recherche | Examinateur |
|---|---|---|
| Munich | 28 février 2011 | Dauw, Xavier |

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 10 19 1969

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | FARANAK HOMAYONI ET AL: "A high gain lateral BJT on thin film silicon substrate", ELECTRON DEVICES AND SOLID-STATE CIRCUITS, 2009. EDSSC 2009. IEEE INTERNATIONAL CONFERENCE OF, IEEE, PISCATAWAY, NJ, USA LNKD- DOI:10.1109/EDSSC.2009.5394267, 25 janvier 2009 (2009-01-25), pages 278-281, XP031616041, ISBN: 978-1-4244-4297-3 * Fig. 1 et texte correspondante. * ----- | 1-10 | |
| A | SAJAD A LOAN ET AL: "A novel high breakdown voltage lateral bipolar transistor on SOI with multizone doping and multistep oxide; A novel high breakdown voltage lateral bipolar transistor on SOI", SEMICONDUCTOR SCIENCE AND TECHNOLOGY, IOP PUBLISHING LTD, GB LNKD- DOI:10.1088/0268-1242/24/2/025017, vol. 24, no. 2, 1 février 2009 (2009-02-01), page 25017, XP020150834, ISSN: 0268-1242 * Par. 4.2 Due to multizone doping;figure 1; tableau 1 * ----- | 1-10 | |
| A | WO 2006/070304 A2 (KONINKL PHILIPS ELECTRONICS NV [NL]; LUDIKHUIZE ADRIANUS W [NL]) 6 juillet 2006 (2006-07-06) * abrégé; figures 2A, 2E * ----- | 1-10 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 28 février 2011 | Dauw, Xavier |

**ANNEXE AU RAPPORT DE RECHERCHE EUROPEENNE
RELATIF A LA DEMANDE DE BREVET EUROPEEN NO.**

EP 10 19 1969

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-02-2011

| Document brevet cité au rapport de recherche | | Date de publication | Membre(s) de la famille de brevet(s) | | Date de publication |
|---|---|---|---|---|---|
| US 6972466 | B1 | 06-12-2005 | US | 7285454 B1 | 23-10-2007 |
| WO 2006070304 | A2 | 06-07-2006 | CN | 101095235 A | 26-12-2007 |
| | | | JP | 2008526039 T | 17-07-2008 |
| | | | US | 2010065885 A1 | 18-03-2010 |

EPO FORM P0460